# EUROPÄISCHE PATENTANMELDUNG

(11) **EP 3 419 066 A1**
(43) Veröffentlichungstag der Anmeldung: **26.12.2018**
(21) Anmeldenummer: 18178597.3
(22) Anmeldetag: 19.06.2018
(51) Int. Cl.: H01L 51/00, H05K 1/11, H05K 3/40, H05K 1/09, H05K 3/24

(54) **FOLIENAUFBAU MIT ELEKTRISCHER FUNKTIONALITÄT UND EXTERNER KONTAKTIERUNG**

(30) Priorität: 21.06.2017 DE 102017113750
(71) Anmelder: Schreiner Group GmbH & Co. KG, 85764 Oberschleissheim (DE)
(72) Erfinder: Kalio, André, 85579 Neubiberg (DE); Gepp, Sebastian, 82256 Fürstenfeldbruck (DE); Hartig, Verena, 80939 München (DE); Barth, Annette, 80689 München (DE); Wittenberg, Marina, 85737 Ismaning (DE)
(74) Vertreter: Epping - Hermann - Fischer

(57) **Zusammenfassung**

Ein Folienaufbau (1, 2) mit elektrischer Funktionalität und externer Kontaktierung umfasst einen Bereich (10) mit einer elektrischen Übertragungsstrecke (30) und einen Kontaktierungsbereich (20) zur externen Kontaktierung der elektrischen Übertragungsstrecke (30). In dem Kontaktierungsbereich (20) des Folienaufbaus ist mindestens eine elektrisch leitfähige Schicht (100), die eine Materialmischung aus Silber und Carbon aufweist, enthalten. Die elektrisch leitfähige Schicht (100) kann sich von dem Kontaktierungsbereich (20) des Folienaufbaus in den Bereich (10) mit der elektrischen Übertragungsstrecke (30) erstrecken und die elektrische Übertragungsstrecke bilden. Die elektrisch leitfähige Schicht (100) kann in dem Kontaktierungsbereich (20) auf einer Leiterbahn (400) angeordnet sein. Die elektrisch leitfähige Schicht (100) ist aufgrund die Mischung aus Silber und Carbon mechanisch und klimatisch stabil.

## Beschreibung

Die Erfindung betrifft einen Folienaufbau mit elektrischer Funktionalität, beispielsweise einer Funktion als Sensor, und einer externen Kontaktierung, um eine elektrisch leifähige Struktur, beispielsweise einen Stecker, mit dem Folienaufbau zu kontaktieren. Des Weiteren betrifft die Erfindung ein Verfahren zum Herstellen eines Folienaufbaus mit elektrischer Funktionalität und externer Kontaktierung.

Folienaufbauten mit elektrischer Funktionalität umfassen im Allgemeinen eine Trägerfolie, auf der eine elektrisch leitfähige Schicht als Leiterbahn angeordnet ist. Die Leiterbahn ist an einer Seite an eine elektrische Schaltung angeschlossen, die ebenfalls auf der Trägerfolie angeordnet sein kann. Die elektrische Schaltung kann beispielsweise in einem RFID-Chip enthalten sein, der auf die Trägerfolie aufgeklebt ist. Das andere Ende der Leiterbahn befindet sich in einem Kontaktierungsbereich des Folienaufbaus, beispielsweise am Rand des Folienaufbaus, und dient zur externen Kontaktierung der Leiterbahn beziehungsweise der elektrischen Schaltung.

Die elektrisch leitfähige Schicht soll in dem Kontaktierungsbereich des Folienaufbaus elektrisch stabil gegen Klimaeinflüsse und mechanisch stabil ausgebildet sein, um einen Stecker, beispielsweise einen ZIF- oder LIF-Stecker, mehrfach nacheinander mit der elektrisch leitfähigen Schicht zu verbinden, ohne die elektrisch leitfähige Schicht zu beschädigen. Der Stecker soll beispielsweise mehrere Male auf den Folienaufbau aufgesteckt und wieder abgezogen werden können, ohne im Kontaktierungsbereich des Folienaufbaus die elektrisch leitfähige Schicht aufgrund der Steckzyklen zu beeinträchtigen. Des Weiteren soll es möglich sein, dass die elektrisch leitfähige Schicht in dem Kontaktierungsbereich des Folienaufbaus trotz einer Vielzahl von Steckzyklen eine hohe Leitfähigkeit aufweist. Darüber hinaus soll die elektrisch leitfähige Schicht auch unter Lasteinfluss, das heißt, wenn Strom anliegt, ihre Funktion als Kontaktierungsschicht erfüllen und eine gute elektrische Leitfähigkeit aufweisen.

Des Weiteren soll vermieden werden, dass die elektrisch leitfähige Schicht im Kontaktierungsbereich unter Einfluss von Temperatur und Feuchteeinfluss korrodiert, wodurch die Leitfähigkeit im Kontaktierungsbereich der elektrisch leitfähigen Schicht herabgesetzt würde.

Ein Anliegen der vorliegenden Erfindung ist es, einen Folienaufbau mit elektrischer Funktionalität und externer Kontaktierung anzugeben, der im Kontaktierungsbereich zur externen Kontaktierung elektrisch stabil gegen Klimaeinflüsse als auch mechanisch stabil ausgebildet ist. Des Weiteren soll ein Herstellverfahren angegeben werden, das die Herstellung eines Folienaufbaus mit elektrischer Funktionalität und externer Kontaktierung ermöglicht, sodass die elektrisch leitfähige Schicht im Kontaktierungsbereich elektrisch stabil gegen Klimaeinflüsse und mechanisch stabil ausgebildet ist.

Ein Folienaufbau mit elektrischer Funktionalität und externer Kontaktierung, bei dem eine elektrisch leifähige Schicht im Kontaktierungsbereich des Folienaufbaus klimatisch und mechanisch robust ausgebildet ist, ist im Patentanspruch 1 angegeben.

Der Folienaufbau umfasst einen Bereich mit einer elektrischen Übertragungsstrecke und einen Kontaktierungsbereich zur externen Kontaktierung der elektrischen Übertragungsstrecke. In dem Kontaktierungsbereich ist mindestens eine elektrisch leitfähige Schicht enthalten, die eine Materialmischung aus Silber und Carbon aufweist.

Gemäß einer ersten Ausführungsform des Folienaufbaus kann sich die elektrisch leitfähige Schicht von dem Kontaktierungsbereich des Folienaufbaus in den Bereich mit der elektrischen Übertragungsstrecke erstrecken. Die elektrisch leitfähige Schicht kann einen ersten Abschnitt, der in dem Kontaktierungsbereich angeordnet ist, und einen zweiten Abschnitt, der in dem Bereich mit der elektrischen Übertragungsstrecke angeordnet ist, aufweisen. Der zweite Abschnitt der elektrisch leitfähigen Schicht bildet die elektrische Übertragungsstrecke.

Die elektrisch leitfähige Schicht kann sowohl im Kontaktierungsbereich des Folienaufbaus als auch im Bereich der elektrischen Übertragungsstrecke auf einer Trägerfolie angeordnet sein. Die Trägerfolie ist als ein flexibles Substrat ausgebildet. Die elektrisch leitfähige Schicht kann insbesondere unmittelbar auf der Trägerfolie angeordnet sein. Beispielsweise kann die elektrisch leitfähige Schicht im Kontaktierungsbereich als auch im Bereich der Übertragungsstrecke auf die Trägerfolie aufgedruckt sein. In dem Bereich des Folienaufbaus mit der elektrischen Übertragungsstrecke kann die elektrisch leitfähige Schicht von einer Isolationsschicht abgedeckt sein. Dadurch ist derjenige Abschnitt der elektrisch leitfähigen Schicht, der die elektrische Übertragungsstrecke realisiert, vor äußeren Einflüssen geschützt.

Gemäß einer zweiten Ausführungsform des Folienaufbaus umfasst der Folienaufbau neben der elektrisch leitfähigen Schicht zusätzlich eine Leiterbahn, die auf der Trägerfolie angeordnet ist. Die Trägerfolie ist als ein flexibles Substrat ausgebildet. Die Leiterbahn kann als eine leitfähige Folie, insbesondere eine Kupfer- oder Aluminiumfolie, ausgebildet sein. Die Leiterbahn ist sowohl in dem Bereich des Folienaufbaus mit der elektrischen Übertragungstrecke als auch in dem Kontaktierungsbereich des Folienaufbaus auf einer Oberseite der Trägerfolie angeordnet.

Bei der zweiten Ausführungsform des Folienaufbaus ist die elektrisch leitfähige Schicht lediglich in dem Kontaktierungsbereich des Folienaufbaus über der Leiterbahn angeordnet. Die elektrisch leitfähige Schicht kann beispielsweise im Kontaktierungsbereich des Folienaufbaus unmittelbar auf der Leiterbahn angeordnet sein. Insbesondere kann die elektrisch leitfähige Schicht im Kontaktierungsbereich des Folienaufbaus auf die Leiterbahn aufgedruckt sein.

Die Materialmischung der elektrisch leitfähigen Schicht aus Silber und Carbon ermöglicht bei den beiden Ausführungsformen des Folienaufbaus die Ausbildung einer kratzfesten, sehr gut leitfähigen Schicht im Kontaktierungsbereich des Folienaufbaus. Die Materialmischung ist mechanisch stabil und erlaubt multiple Steckzyklen beim Aufstecken eines Steckers, beispielsweise eines ZIF- oder LIF-Steckers, auf den Folienaufbau.

Insbesondere führt der Carbonanteil der Mischung dazu, dass die elektrisch leitfähige Schicht im Kontaktierungsbereich mechanisch robust, insbesondere kratzest ist, sodass ein mehrmaliges Kontaktieren des Folienaufbaus durch einen Steckerverbinder nicht zu einer unmittelbaren Beschädigung der elektrisch leitfähigen Schicht führt. Die hohe elektrische Leitfähigkeit der elektrisch leitfähigen Schicht ist insbesondere durch den Silberanteil in der Materialmischung bedingt. Aufgrund der hohen Leitfähigkeit der elektrisch leitfähigen Schicht sind Kontaktwiderstände zu einem Stecker oder einer anderen elektrischen Struktur, die im Kontaktierungsbereich des Folienaufbaus mit der elektrisch leitfähigen Schicht verbunden wird, gering.

Die Materialmischung aus Silber und Carbon ist darüber hinaus klimatisch stabil. Dadurch ermöglicht die Materialmischung im Kontaktierungsbereich des Folienaufbaus die Ausbildung einer elektrisch leitfähigen Schicht mit einem elektrisch leitfähigen Korrosionsschutz. Bei der zweiten Ausführungsform wird mit der elektrisch leitfähigen Schicht ein elektrisch leitfähiger Korrosionsschutz im Kontaktierungsbereich unmittelbar auf die Leiterbahn aufgedruckt.

Grundsätzlich sind Mischungsverhältnisse im gesamten Mischbereich von Silber und Carbon möglich. Dies bedeutet, dass der Silberanteil größer als 0 % und kleiner als 100 % beziehungsweise der Carbonanteil kleiner als 100 % und größer als 0 % sein kann. Als besonders vorteilhaft, insbesondere mechanisch robust für Steckeranwendungen, hat sich eine Materialmischung ergeben, bei der der Silberanteil kleiner als 100% und größer als 40 % und der Carbonanteil größer als 0 % und kleiner als 60 % ist.

Eine Ausführungsform eines Verfahrens zum Herstellen des Folienaufbaus mit elektrischer Funktionalität und externer Kontaktierung, bei dem ein Kontaktierungsbereich klimatisch und mechanisch stabil ausgebildet ist, ist im Patentanspruch 10 angegeben.

Das Verfahren sieht das Bereitstellen des Folienaufbaus mit einer Trägerfolie vor, wobei der Folienaufbau einen Bereich mit einer elektrischen Übertragungsstrecke und einen Kontaktierungsbereich zur externen Kontaktierung der elektrischen Übertragungsstrecke aufweist. Es wird eine Materialmischung aus Silber und Carbon hergestellt. Diese Materialmischung wird als elektrisch leitfähige Schicht in dem Kontaktierungsbereich des Folienaufbaus oberhalb der Trägerfolie aufgedruckt.

Zur Herstellung der ersten Ausführungsform des Folienaufbaus wird die Materialmischung aus Silber und Carbon in dem Bereich des Folienaufbaus mit der elektrischen Übertragungsstrecke und in dem Kontaktierungsbereich des Folienaufbaus unmittelbar auf die Trägerfolie aufgedruckt. Die elektrisch leitfähige Schicht bildet die elektrische Übertragungsstrecke. Der gesamte folienbasierte Sensor kann aus der Materialmischung gedruckt sein.

Zur Herstellung der zweiten Ausführung des Folienaufbaus wird auf die Trägerfolie eine Leiterbahn aufgebracht. Die Leiterbahn kann beispielsweise eine leitfähige Folie, insbesondere eine Kupferfolie oder eine Aluminiumfolie, sein, die auf der Trägerfolie angeordnet wird. Die leitfähige Folie kann auf die Trägerfolie aufgeklebt werden und anschließend mittels Ätzbädern und/oder Stanzen zu der Leiterbahn strukturiert werden. Die Strukturierung kann auch mittels anderer subtraktiver Verfahren, zum Beispiel durch Verwendung eines Lasers oder durch Fräßen, erfolgen. In dem Kontaktierungsbereich des Folienaufbaus wird die Materialmischung aus Silber und Carbon unmittelbar auf die Leiterbahn aufgedruckt.

Die Materialmischung aus Silber und Carbon kann beispielsweise mittels Siebdruck, Flexodruck, Inkjet-Druck oder gegebenenfalls Tampondruck auf die Trägerfolie oder auf die Leiterbahn aufgedruckt werden. Die Materialmischung kann auch durch Dispensen aufgebracht werden. Durch den Einsatz eines Druckverfahrens zum Aufbringen der Materialmischung aus Silber und Carbon auf den Folienaufbau kann der angegebene Folienaufbau in einem Herstellverfahren von Rolle zu Rolle oder als Bogenware produziert werden.

Die elektrisch leitfähige Schicht lässt sich nach der Herstellung der Materialmischung aus Silber und Carbon durch einen einzigen Druckschritt bei der ersten Ausführungsform sowohl im Kontaktierungsbereich als auch im Bereich des Folienaufbaus mit der elektrischen Übertragungsstrecke auf die Trägerschicht aufbringen.

Bei der zweiten Ausführungsform kann die Materialmischung durch einen einzigen Druckschritt im Kontaktierungsbereich unmittelbar auf die Leiterbahn aufgebracht werden. Wenn die Materialmischung aus Silber und Carbon im Kontaktierungsbereich des Folienaufbaus unmittelbar auf der Leiterbahn angeordnet wird, entsteht in nur einem Prozessschritt ein elektrisch leitfähiger Korrosionsschutz, der ein Korrodieren der Leiterbahn, beispielsweise einer strukturierten Aluminium- oder Kupferfolie, verhindert.

Im Unterschied zu einer Ausführungsform, bei der das Silber und Carbon als separate Lagen übereinander gedruckt werden, und dazu mindestens zwei Druckschritte erforderlich sind, ist das erfindungsgemäße Herstellverfahren mit deutlich weniger Aufwand, nämlich nur mit einem einzigen Druckschritt zum Aufbringen der elektrisch leitfähigen Schicht, verbunden.

Bei einem Zwei- oder Mehrschichtdruckprozess würden außerdem die auftretenden Drucktoleranzen kleine Abstände der Kontaktanschlüsse im Steckerbereich erschweren oder sogar gänzlich verhindern. Da das angegebene Verfahren lediglich mit einem einzigen Druckschritt auskommt, entfällt die enge Passertoleranz, insbesondere bei Steckkontaktabständen (Pitches) ≤ 1 mm. Des Weiteren weist das Verfahren durch das Aufbringen der Materialmischung aus Silber und Carbon in einem einzigen Druckschritt eine geringere Prozesszeit und Ausschussrate auf, als wenn zunächst eine reine Silberschicht auf die Trägerfolie beziehungsweise die Leiterbahn gedruckt würde und darüber eine reine Carbonschicht in zwei getrennten Druckschritten aufgebracht würde.

Die Erfindung wird im Folgenden anhand von Figuren, die Ausführungsbeispiele der vorliegenden Erfindung zeigen, näher erläutert. Es zeigen:
Figur 1A und 1B eine erste Ausführungsform eines Folienaufbaus mit elektrischer Funktionalität und externer Kontaktierung in einer Queransicht,
Figur 2 eine Draufsicht auf einen Folienaufbau mit elektrischer Funktionalität und externer Kontaktierung,
Figur 3 eine zweite Ausführungsform eines Folienaufbaus mit elektrischer Funktionalität und externer Kontaktierung in einer Queransicht,
Figur 4 den Verlauf eines Schichtwiderstands einer Silber-/Carbon-Mischung in Abhängigkeit von einem Mischungsverhältnis.

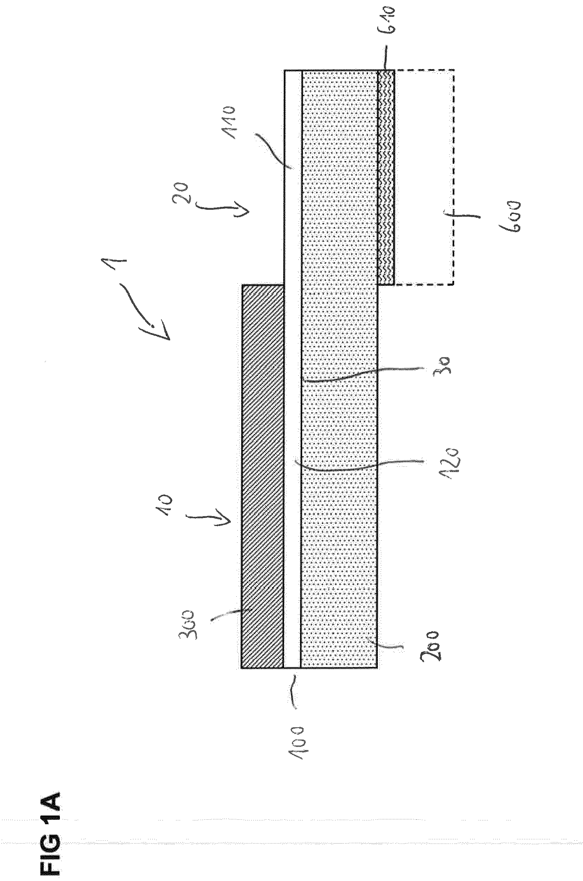

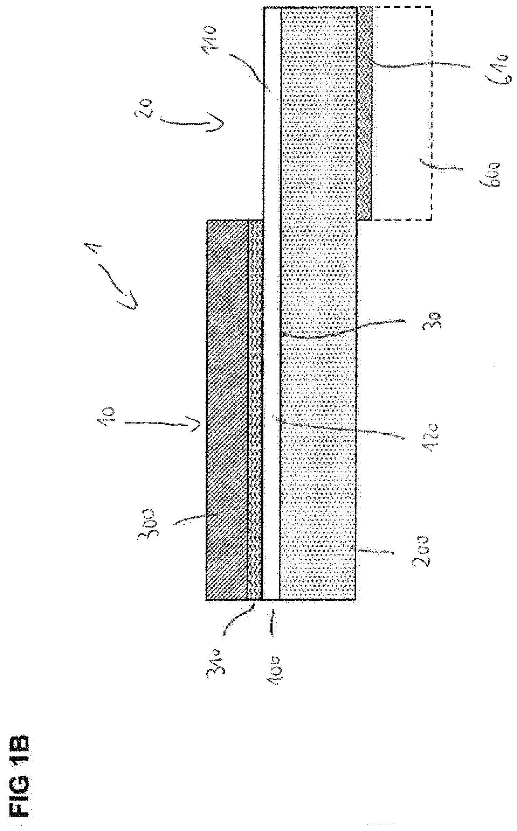

Die Figuren 1A und 1B zeigen Ausführungsformen eines Folienaufbaus 1 mit elektrischer Funktionalität und externer Kontaktierung in einer Queransicht. Der Folienaufbau 1 weist einen Bereich 10 mit einer elektrischen Übertragungsstrecke 30 und einen Kontaktierungsbereich 20 zur externen Kontaktierung der elektrischen Übertragungsstrecke 30 auf. In dem Kontaktierungsbereich 20 ist mindestens eine elektrisch leifähige Schicht 100 enthalten, die eine Materialmischung aus Silber und Carbon aufweist.

Bei den in den Figuren 1A und 1B gezeigten Ausführungsformen des Folienaufbaus 1 erstreckt sich die elektrisch leitfähige Schicht 100 von dem Kontaktierungsbereich 20 in den Bereich 10 mit der elektrischen Übertragungsstrecke 30. Die elektrisch leitfähige Schicht 100 weist einen Abschnitt 110 auf, der in dem Kontaktierungsbereich 20 des Folienaufbaus 1 angeordnet ist. Des Weiteren umfasst die elektrisch leitfähige Schicht 100 einen sich an den Abschnitt 110 anschließenden Abschnitt 120, der in dem Bereich 10 des Folienaufbaus mit der elektrischen Übertragungsstrecke 30 angeordnet ist. Die elektrisch leitfähige Schicht 100 bildet in dem Kontaktierungsbereich 20 eine Kontaktierungsschicht zur externen Kontaktierung des Folienaufbaus. In dem Bereich 10 des Folienaufbaus bildet die elektrisch leitfähige Schicht 100 die elektrische Übertragungsstrecke 30.

Der Folienaufbau umfasst weiterhin eine Trägerfolie 200, die als ein flexibles Trägersubstrat für die elektrisch leitfähige Schicht 100 dient. Der Abschnitt 110 und der Abschnitt 120 der elektrisch leitfähigen Schicht 100 sind auf der Trägerfolie 200 angeordnet. Bei der in Figur 1 gezeigten Ausführungsform sind die beiden Abschnitte 110 und 120 der elektrisch leitfähigen Schicht 100 unmittelbar auf der Trägerfolie 200 angeordnet. Die elektrisch leitfähige Schicht 100 kann beispielsweise eine Schichtdicke zwischen 3 µm und 30 µm aufweisen. Bei Verwendung eines Inkjet-Druckverfahrens kann die elektrisch leitfähige Schicht sogar noch dünner sein, zum Beispiel nur 0,5 µm betragen. Die Trägerfolie 200 kann eine Schichtdicke zwischen 25 µm und 500 µm aufweisen. Die Trägerfolie kann als eine PET-, PC-, PEN- PI- oder PU-Folie ausgebildet sein.

Unter der Trägerfolie 200 kann im Kontaktierungsbereich 20 des Folienaufbaus eine Verstärkungsschicht 600 angeordnet sein. Die Verstärkungsschicht 600 kann als eine Stiffnerfolie ausgebildet sein, die mittels einer Kleberschicht 610 im Kontaktierungsbereich 20 des Folienaufbaus unterseitig an der Verstärkungsschicht 600 angeordnet ist. Die Verstärkungsschicht kann als eine PET-, PC-, PEN-, PI- oder PU-Folie ausgebildet sein. Die Verstärkungsschicht 600 kann eine Schichtdicke zwischen 125 µm und 225 µm aufweisen. Durch die Verstärkungsschicht 600 können gegebenenfalls Bauteiltoleranzen in einem Steckergehäuse, in dem der Kontaktierungsbereich 20 des Folienaufbaus angeordnet ist, ausgeglichen werden. Die Summe der Folien liegt für die meisten Stecker zwischen 250 µm und 350 µm.

Der Folienaufbau 1 umfasst weiterhin eine Isolationsschicht 300. Die Isolationsschicht 300 ist über dem Abschnitt 120 der elektrisch leitfähigen Schicht 100 angeordnet, sodass der Abschnitt 120 der elektrisch leitfähigen Schicht 100 von der Isolationsschicht 300 bedeckt und somit vor äußeren Einflüssen geschützt ist. Die Isolationsschicht 300 kann eine Schichtdicke zwischen 1 µm und 175 µm aufweisen. Im Kontaktierungsbereich 20 des Folienaufbaus liegt die elektrisch leitfähige Schicht 100 hingegen frei, um mit einer elektrischen Anschlussstruktur verbunden zu werden.

Die Isolationsschicht 300 kann beispielsweise als ein Isolationslack ausgebildet sein, der auf dem Abschnitt 120 der elektrisch leitfähigen Schicht 100 angeordnet ist. Eine derartige Ausgestaltung des Folienaufbaus 1 ist in Figur 1A dargestellt. Als Isolationslack kann ein UV-Lack, beispielsweise aus einem UV-aushärtendem Polymer, oder ein lösemittelbasierender Lack verwendet werden. Gemäß einer weiteren in Figur 1B dargestellten Ausführungsvariante des Folienaufbaus 1 kann die Isolationsschicht als eine Isolationsfolie, insbesondere als eine PET-, PC-, PEN-, PI-, PU-Folie oder weitere Folie, ausgebildet sein. Die Isolationsfolie ist mittels einer Kleberschicht 310 mit der elektrisch leitfähigen Schicht 100 verbunden.

Der Kontaktierungsbereich 20 ist als ein Bereich ausgebildet, an dem die elektrisch leitfähige Schicht 100 mit einer elektrischen Anschlussstruktur verbunden werden kann. Die elektrische Anschlussstruktur kann beispielsweise ein Stecker sein, der auf den Folienaufbau aufgesteckt wird, dabei kann es sich zum Beispiel um einen ZIF- oder LIF-Steckerverbinder handeln. Dadurch kann eine elektrische Anschlussstruktur im Kontaktierungsbereich 20 auswechselbar mit dem Folienaufbau verbunden werden. Des Weiteren besteht die Möglichkeit, im Kontaktierungsbereich 20 auf der elektrisch leitfähigen Schicht 100 einen Leitkleber aufzutragen, um dadurch eine elektrische Anschlussstruktur, beispielsweise eine Leiterplatte, mit der elektrisch leitfähigen Schicht 100 des Folienaufbaus zu kontaktieren. Es besteht darüber hinaus die Möglichkeit, durch Crimpen, Nieten oder ein ähnliches Verbindungsverfahren im Kontaktierungsbereich 20 des Folienaufbaus eine Verbindung zwischen dem Folienaufbau 1 und der elektrischen Anschlussstruktur zu schaffen. Die Materialpaarung der Verbindung muss aufeinander abgestimmt sein.

Die Verwendung einer Materialmischung aus Silber und Carbon ermöglicht die Herstellung einer elektrisch gegen Klimaeinflüsse stabilen und auch mechanisch stabilen elektrisch leitfähigen Schicht 100 im Kontaktierungsbereich 20. Während die elektrisch leitfähige Schicht durch den Silberanteil eine hohe Leitfähigkeit und damit niedrige Kontaktwiderstände aufweist, entsteht durch das Hinzumischen von Carbon zu dem Silber eine kratzfeste leitfähige Schicht.

Dadurch kann ein Stecker, beispielsweise ein ZIF- oder LIF-Stecker, an den Kontaktierungsbereich angeschlossen werden, ohne dass die leitfähige Schicht 100 im Kontaktierungsbereich 20 signifikant beschädigt wird. Aufgrund der mechanischen Robustheit der elektrisch leitfähigen Schicht 100 sind multiple Steckzyklen möglich, ohne dass die elektrisch leitfähige Schicht 100 im Kontaktierungsbereich 20 signifikant beschädigt wird. Ein Stecker kann somit mehrfach auf den Folienaufbau aufgesteckt und wieder abgezogen werden, ohne dass der erste Abschnitt 110 der elektrisch leitfähigen Schicht 100 im Kontaktierungsbereich 20 des Folienaufbaus durch Abrieb beschädigt wird.

Die hohe Kratzfestigkeit wird insbesondere durch den Carbonanteil der Materialmischung bewirkt. Die Materialmischung aus Silber und Carbon ist deutlich kratzfester, als wenn im Kontaktierungsbereich 20 eine reine Silberpaste verwendet würde. Die Verwendung einer reiner Carbonpaste im Kontaktierungsbereich 20 hätte zwar ebenfalls gute Eigenschaften bezüglich der mechanischen Stabilität, jedoch weist Carbon nur eine geringe Leitfähigkeit auf. Carbon allein erhöht den Kontaktwiderstand auf A1 und Cu und reagiert mit dem Metall, falls keine Goldschicht dazwischen eingebrachte wurde. Hingegen ermöglicht die Verwendung einer Materialmischung aus Silber und Carbon die Herstellung einer elektrisch leitfähigen Schicht 100 als eine mechanisch stabile, insbesondere kratzfeste Schicht mit hoher Leitfähigkeit.

Zur Herstellung des in Figur 1 gezeigten Folienaufbaus 1 wird zunächst eine Trägerfolie 200 bereitgestellt. Anschließend wird die Materialmischung aus Silber und Carbon hergestellt. Dazu kann beispielsweise zu einer Silberpaste eine Carbonpaste hinzugemischt werden. Alternativ besteht die Möglichkeit, direkt die Carbon- und Silberpartikel mit geeigneten Bindemitteln zu mischen. Beispielsweise können die Carbon- und Silberpartikel während der Produktion in eine Paste eingemischt werden. Die Materialmischung aus Silber und Carbon enthält ein Bindemittel. Die Paste enthält ein Lösemittel kleiner als 30wt%, insbesondere wenn ein Siebdruck-Verfahren verwendet wird. Bei anderen Verfahren kann der Lösemittelanteil auch deutlich höher liegen. Zum Aufbringen der Materialmischung auf die Trägerfolie kann ein Druckverfahren, beispielsweise ein Siebdruckverfahren, ein Flexodruckverfahren, ein Tampondruckverfahren oder sonstiges Verfahren, verwendet werden. Die Materialmischung aus Silber und Carbon wird als eine elektrisch leitfähige Schicht 100 in dem Bereich 10 als auch in dem Kontaktierungsbereich 20 des Folienaufbaus unmittelbar auf die Trägerfolie 200 aufgedruckt. Weiterhin besteht die Möglichkeit, die Materialmischung aus Silber und Carbon durch Dispensen oder durch ein Tintenstrahlverfahren (Inkjet) auf die Trägerfolie aufzubringen. Die gedruckte Silber-Carbon-Mischung kann lösemittelbasierend sein. Alternativ dazu kann die Silber-Carbon Mischung als eine mittels UV-Licht aushärtbare Schicht ausgebildet sein. Die Schicht 100 trocknet bei Temperaturen zwischen 60°C und 130°C.

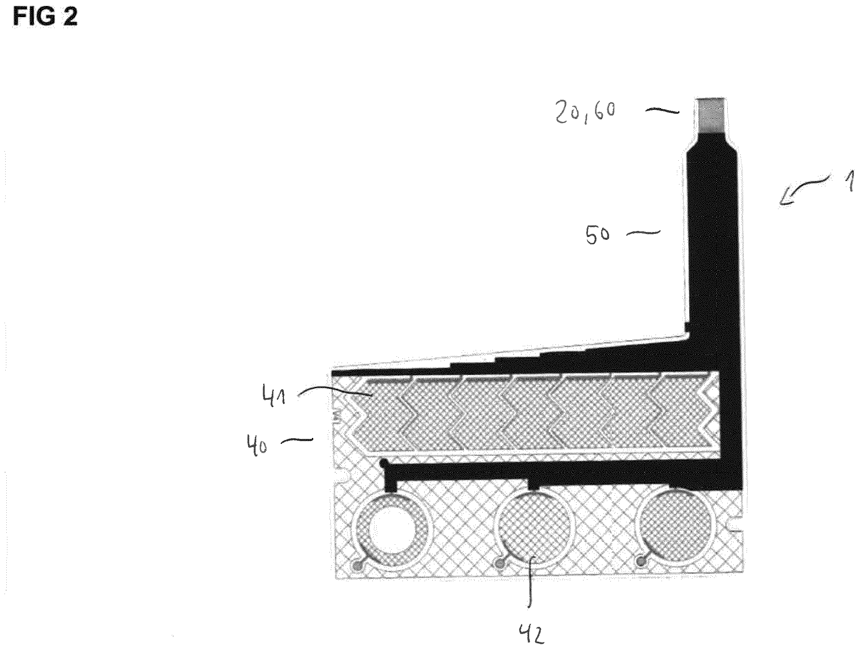

Figur 2 zeigt eine Draufsicht auf ein Ausführungsbeispiel des Folienaufbaus 1. Der Folienaufbau weist eine Sensorfläche 40 mit einem ersten Sensorbereich 41 und einem zweiten Sensorbereich 42 auf. Des Weiteren umfasst der Folienaufbau 1 eine Anschlussfahne 50, in dem ein Teil des Bereichs 10 mit der elektrischen Übertragungsstrecke angeordnet ist, und einen Kontaktierungsbereich 20, der als Steckerfläche 60 zum Aufstecken eines Steckers ausgebildet ist.

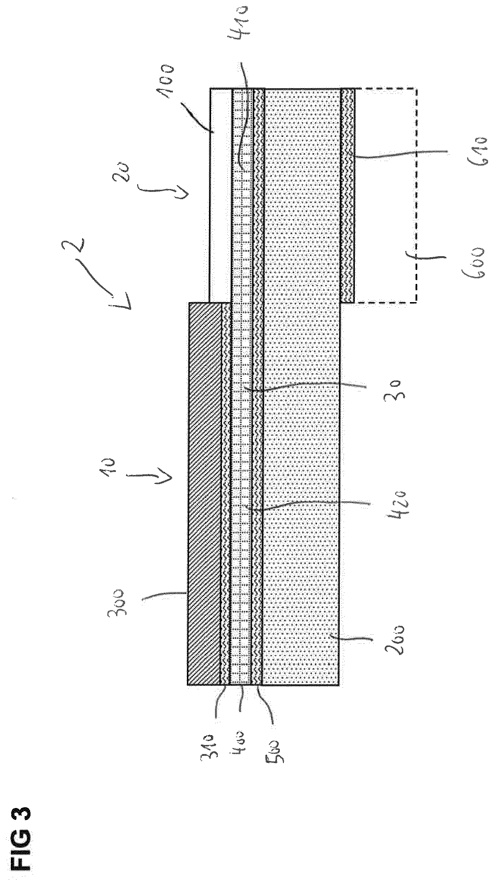

Figur 3 zeigt eine zweite Ausführungsform eines Folienaufbaus 2 mit elektrischer Funktionalität und externer Kontaktierung. Wie bei den in den Figuren 1A und 1B gezeigten Ausführungsformen des Folienaufbaus umfasst der Folienaufbau 2 einen Bereich 10 mit einer elektrischen Übertragungsstrecke 30 und einen Kontaktierungsbereich 20 zur externen Kontaktierung der elektrischen Übertragungsstrecke 30. Bei der in Figur 3 gezeigten Ausführungsform des Folienaufbaus 2 ist die mindestens eine elektrisch leitfähige Schicht 100 lediglich in dem Kontaktierungsbereich 20 enthalten. Die elektrisch leitfähige Schicht 100 weist ebenfalls eine Materialmischung aus Silber und Carbon auf. Die elektrisch leitfähige Schicht 100 kann beispielsweise eine Schichtdicke zwischen 0,5 µm und 30 µm aufweisen.

Der Folienaufbau 2 umfasst eine Trägerfolie 200, eine Isolationsschicht 300 und eine Leiterbahn 400. Optional kann in dem Kontaktierungsbereich 20 unterhalb der Trägerfolie 200 eine Verstärkungsschicht 600 angeordnet sein. Die Verstärkungsschicht 600 kann wie bei der ersten Ausführungsform des Folienaufbaus 1 beschrieben ausgebildet sein. Wie bei der ersten Ausführungsform des Folienaufbaus 1 können durch die Verstärkungsschicht 600 Bauteiltoleranzen in einem Steckergehäuse oder einer sonstigen Aufnahme, in dem der Kontaktierungsbereich 20 des Folienaufbaus angeordnet wird, ausgeglichen werden.

Die Trägerfolie 200 ist als eine flexible Substratschicht ausgebildet. Die Schichtdicke der Trägerfolie 200 beträgt üblicherweise bis zu 250 µm. Die Trägerfolie kann als eine PET-, PC-, PEN-, PI- oder PU-Folie ausgebildet sein. Die Leiterbahn 400 ist auf der Trägerfolie 200 angeordnet und erstreckt sich von dem Kontaktierungsbereich 20 in den Bereich 10 des Folienaufbaus mit der elektrischen Übertragungsstrecke 30. Die Leiterbahn 400 kann als eine Aluminium- oder Kupferleiterbahn, beispielsweise als eine Aluminium- oder Kupferfolie ausgebildet sein.

Die Leiterbahn 400 weist einen Abschnitt 410 auf, der in dem Kontaktierungsbereich 20 des Folienaufbaus angeordnet ist. Des Weiteren weist die Leiterbahn 400 einen sich an den Abschnitt 410 anschließenden Abschnitt 420 auf, der in dem Bereich 10 des Folienaufbaus angeordnet ist. Der Abschnitt 420 der Leiterbahn 400 bildet in dem Bereich 10 des Folienaufbaus 2 die elektrische Übertragungsstrecke 30. Die Leiterbahn 400 kann ein leitfähiges Metall, insbesondere Kupfer, Aluminium oder Eisen, Silber, Gold, Messing (CuyZnx-Legierung), enthalten. Anstelle eines Metalls kann für die Leiterbahn 400 auch ein Leitlack verwendet werden, der auf der Trägerfolie 200 aufgebracht wird. Weiterhin kann eine Ito-Beschichtung mit Laserstrukturierung und einer Ca/Ag-Mischung als Kontaktierung verwendet werden. Die Schichtdicke der Leiterbahn 400 kann zwischen 0,5 µm und 150 µm betragen.

Die elektrisch leitfähige Schicht 100 ist nur auf dem Abschnitt 410 der Leiterbahn 400 angeordnet. Der Abschnitt 420 der Leiterbahn 400 ist von der Isolationsschicht 300 bedeckt. Die Isolationsschicht 300 kann eine Folie oder ein Isolationslack zum Schutz der Leiterbahn 400 im Bereich 10 des Folienaufbaus sein. Der Einfachheit halber ist in Figur 3 nur eine Ausführungsvariante gezeigt, bei der die Isolationsschicht 300 als eine Folie ausgebildet ist, die mittels der Kleberschicht 310 auf den Abschnitt 420 der Leiterbahn 400 aufgeklebt ist. Wie bei der in Figur 1 gezeigten Ausführungsform des Folienaufbaus 1 liegt die elektrisch leitfähige Schicht 100 im Kontaktierungsbereich 20 des Folienaufbaus 2 frei, um mit einer elektrischen Anschlussstruktur verbunden werden zu können.

Zur Herstellung des in Figur 3 gezeigten Folienaufbaus 2 wird zunächst die Trägerfolie 200 bereitgestellt. Anschließend wird die Leiterbahn 400 auf der Trägerfolie 200 aufgebracht. Wenn für die Leiterbahn 400 ein leitfähiges Metall, beispielsweise Kupfer oder Aluminium, verwendet wird, kann die Leiterbahn 400 zunächst in Form einer Metallfolie, das heißt einer Kupfer- oder Aluminiumfolie, ganzflächig auf der Trägerfolie 200 angeordnet werden. Eine derartige Metallfolie kann beispielsweise mittels der in Figur 3 gezeigten Kleberschicht 500 auf die Trägerfolie 200 aufgeklebt werden. Alternativ dazu kann die Leiterbahn 400 auf die Trägerfolie 200 aufgedampft sein. Die Metallfolie kann anschließend mittels Ätzbäder und/oder Stanzen zu der Leiterbahn 400 strukturiert werden.

Die Materialmischung aus Silber und Carbon wird anschließend in dem Kontaktierungsbereich 20 des Folienaufbaus auf dem Abschnitt 410 der Leiterbahn 400 angeordnet. Die Materialmischung aus Silber und Carbon kann insbesondere im Kontaktierungsbereich 20 des Folienaufbaus auf die Leiterbahn 400 aufgedruckt werden. Zum Aufdrucken der Materialmischung aus Silber und Carbon auf den Abschnitt 410 der Leiterbahn 400 kann wie bei der Ausführungsform des Folienaufbaus 1 ein Siebdruck-, Flexodruck- oder Tampondruckverfahren verwendet werden. Ebenso besteht die Möglichkeit, die Materialmischung aus Silber und Carbon durch Dispensen oder mit Hilfe eines Tintenstrahldruckverfahrens (Inkjet) auf den Abschnitt 410 der Leiterbahn 400 aufzutragen.

In dem Bereich 10 des Folienaufbaus wird die Isolationsschicht 300 auf den Abschnitt 420 der Leiterbahn 400 aufgebracht. Die elektrisch leitfähige Schicht 100 liegt in dem Kontaktierungsbereich 20 des Folienaufbaus frei, um mit einer elektrischen Anschlussstruktur verbunden werden zu können. Die elektrische Anschlussstruktur kann ein Stecker, beispielsweise ein ZIF- oder LIF-Stecker, sein, der durch Aufstecken auf den Kontaktierungsbereich 20 mit dem Folienaufbau auswechselbar verbunden werden kann. Die elektrische Anschlussstruktur kann auch mittels eines Leitklebers, in flüssiger Form oder als Klebeband, oder durch Crimpen mit der elektrisch leitfähigen Schicht 100 verbunden werden.

Wie oben erläutert, wird zur Herstellung der Leiterbahn 400 eine Metallfolie nach dem Aufkleben auf die Trägerfolie 200 mittels Ätzbäder und/oder Lasern/Stanzen strukturiert. Unter dem Einfluss von Temperatur und Feuchte kann die Leiterbahn 400 allerdings korrodieren. Dabei bildet sich bei Verwendung einer Aluminiumfolie als Leiterbahn 400 Aluminiumoxid und bei Verwendung einer Kupferfolie als Leiterbahn Kupferoxid. In dem Bereich 10 des Folienaufbaus ist die Leiterbahn 400 aufgrund der Isolationsschicht 200 vor einer Korrosion weitestgehend geschützt. Die in dem Kontaktierungsbereich 20 vorgesehene elektrisch leitfähige Schicht 100 aus der Materialmischung aus Silber und Carbon stellt für den Abschnitt 410 der Leiterbahn 400 einen elektrisch leitfähigen Korrosionsschutz dar.

Die Verwendung einer reinen Carbonpaste im Kontaktierungsbereich 20 über der Leiterbahn 400 würde zu einer Korrosion mit der Leiterbahn 400, beispielsweise einer Metallfolie, führen). Des Weiteren tritt bei Verwendung einer reinen Carbonpaste eine erhebliche Widerstandserhöhung im Kontaktierungsbereich 20 auf Grund der Korrosion auf. Wenn für den Abschnitt 410 der Leiterbahn 400 reines Silber verwendet würde, das beispielsweise auf die Trägerfolie 200 aufgedruckt würde, wäre der Korrosionsschutz zwar gegeben. Allerdings ergeben sich bei Verwendung einer reinen Silberschicht für die Leiterbahn 400 Probleme bei einem mehrmaligen Kontaktieren des Folienaufbaus im Kontaktierungsbereich 20 durch einen Steckerverbinder. Dies ist dadurch bedingt, dass gedrucktes Silber zwar elektrisch gut leitend, aber nicht kratzfest ist.

Durch die Verwendung einer Materialmischung aus Silber und Carbon kann auf dem Abschnitt 410 der Leiterbahn 400 eine elektrisch leitfähige Schicht 100 aufgebracht werden, bei der die korrosiven Eigenschaften von Carbon mit der darunterliegenden Leiterbahn 400 aufgrund des Silberanteils der Mischung verringert sind und die aufgrund des Carbonanteils der Mischung mechanisch robust ist, um somit mehrmals mit einem Steckverbinder, beispielsweise mit Knackfröschen, Metallfedern oder Kontaktstiften, kontaktiert werden zu können.

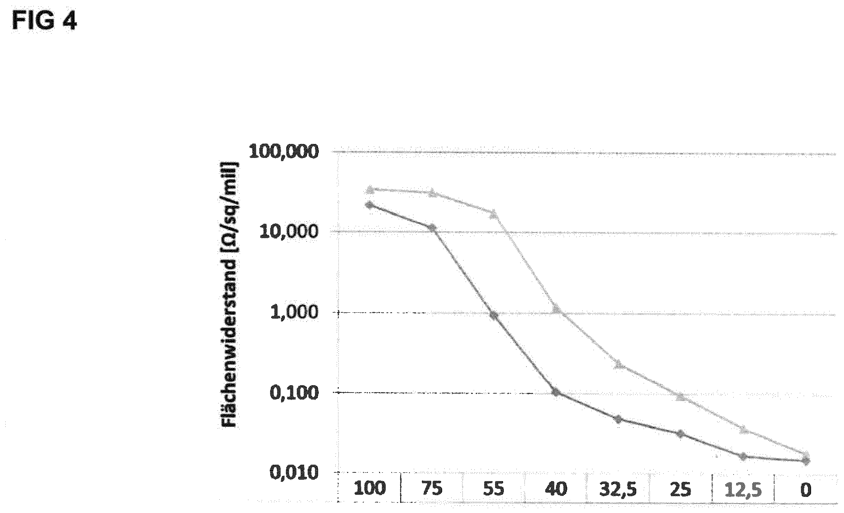

Figur 4 zeigt den Verlauf eines Flächenwiderstands der elektrisch leitfähigen Schicht 100 in Abhängigkeit von dem Mischungsverhältnis aus Carbon und Silber. Auf der x-Achse ist der Carbonanteil der Mischung und auf der y-Achse der Widerstand in Ω/sq/mil angegeben. Der elektrische Widerstand der elektrisch leitfähigen Schicht 100 lässt sich durch das Mischungsverhältnis von Silber und Carbon einstellen. Grundsätzlich kann für die Materialmischung der elektrisch leitfähigen Schicht 100 der gesamte Mischbereich von Silber und Carbon, das heißt für den Silberanteil ein Bereich von größer als 0% und kleiner als 100% und entsprechend für den Carbonanteil der Mischung ein Bereich von kleiner als 100% und größer als 0%, verwendet werden.

Zur Herstellung einer mechanisch robusten elektrisch leitfähigen Schicht im Kontaktierungsbereich 20 des Folienaufbaus hat sich eine Materialmischung aus Silber und Carbon mit einem Silberanteil von kleiner als 100 % und größer als 40 % und mit einem Carbonanteil von größer als 0 % und kleiner als 60 % als besonders geeignet herausgestellt. Eine elektrisch leitfähige Schicht 100 aus einer derartigen Materialmischung weist eine hohe Leitfähigkeit auf und ist mechanisch robust, insbesondere kratzfest, um auch bei einem mehrmaligen Kontaktieren des Folienaufbaus mit einem Stecker nicht signifikant beschädigt zu werden.

Zum Schutz vor Korrosion hat sich bei Verwendung einer Kupferfolie für die Leiterbahn 400 eine Mischung aus 40 % Carbon und 60 % Silber gedruckt als leitfähige Schicht auf die Kupferfolie als besonders geeignet herausgestellt. Eine Materialmischung aus 40 % Carbon und 60 % Silber für die elektrisch leitfähige Schicht 100, die auf einen als Kupferfolie ausgebildeten Leiterbahnabschnitt 410 gedruckt wird, führt zu einer absoluten Widerstandsänderung von 0,47 Ω auf 0,59 Ω über 1000 Stunden bei 85 °C und einer relativen Feuchte von 85 %. Bei Verwendung einer Aluminiumfolie für die Leiterbahn 400 hat sich für die elektrisch leitfähige Schicht 100 ein Mischungsverhältnis von 12,5 % Carbon und 87,5 % Silber mit einer absoluten Änderung von 0,7 Ω bei gleicher Lagerung als besonders vorteilhaft herausgestellt.

### Bezugszeichenliste

- 1,2: Folienaufbau
- 10: Bereich mit Übertragungsstrecke
- 20: Kontaktierungsbereich
- 30: Übertragungsstrecke
- 100: elektrisch leitfähige Schicht
- 200: Trägerfolie
- 300: Isolationsschicht
- 400: Leiterbahn
- 500: Kleberschicht
- 600: Verstärkungsschicht

## Patentansprüche

1. Folienaufbau mit elektrischer Funktionalität und externer Kontaktierung, umfassend:
- einen Bereich (10) mit einer elektrischen Übertragungsstrecke (30),
- einen Kontaktierungsbereich (20) zur externen Kontaktierung der elektrischen Übertragungsstrecke (30),
- wobei in dem Kontaktierungsbereich (20) mindestens eine elektrisch leitfähige Schicht (100), die eine Materialmischung aus Silber und Carbon aufweist, enthalten ist.

2. Folienaufbau nach Anspruch 1,
- wobei sich die elektrisch leitfähige Schicht (100) von dem Kontaktierungsbereich (20) in den Bereich (10) mit der elektrischen Übertragungsstrecke (30) erstreckt,
- wobei die elektrisch leitfähige Schicht (100) einen ersten Abschnitt (110), der in dem Kontaktierungsbereich (20) des Folienaufbaus (1) angeordnet ist, und einen sich daran anschließenden zweiten Abschnitt (120), der in dem Bereich (10) des Folienaufbaus mit der elektrischen Übertragungsstrecke (30) angeordnet ist und die elektrische Übertragungsstrecke (30) bildet, aufweist.

3. Folienaufbau nach einem der Ansprüche 1 oder 2, umfassend:
eine Trägerfolie (200), wobei der erste und zweite Abschnitt der elektrisch leitfähigen Schicht (110, 120) auf der Trägerfolie (200) angeordnet sind.

4. Folienaufbau nach einem der Ansprüche 1 bis 3, umfassend:
- eine Isolationsschicht (300),
- wobei der zweite Abschnitt (120) der elektrisch leitfähigen Schicht (100) von der Isolationsschicht (300) bedeckt ist.

5. Folienaufbau nach Anspruch 1, umfassend:
- eine Leiterbahn (400), die sich von dem Kontaktierungsbereich (20) in den Bereich (10) des Folienaufbaus mit der elektrischen Übertragungsstrecke (30) erstreckt,
- wobei die Leiterbahn (400) einen ersten Abschnitt (410), der in dem Kontaktierungsbereich (20) des Folienaufbaus angeordnet ist, und einen sich daran anschließenden zweiten Abschnitt (420), der in dem Bereich (20) des Folienaufbaus mit der elektrischen Übertragungsstrecke (30) angeordnet ist und die elektrische Übertragungsstrecke (30) bildet, aufweist,
- wobei die elektrisch leitfähige Schicht (100) auf dem ersten Abschnitt (410) der Leiterbahn (400) angeordnet ist.

6. Folienaufbau nach Anspruch 5, umfassend:
eine Trägerfolie (200), wobei der erste und zweite Abschnitt (410, 420) der Leiterbahn (400) auf der Trägerfolie (200) angeordnet sind.

7. Folienaufbau nach einem der Ansprüche 5 oder 6, umfassend:
- eine Isolationsschicht (300),
- wobei der zweite Abschnitt (420) der Leiterbahn (400) von der Isolationsschicht (300) bedeckt ist.

8. Folienaufbau nach einem der Ansprüche 1 bis 7
wobei die elektrisch leitfähige Schicht (100) in dem Kontaktierungsbereich (20) des Folienaufbaus freiliegend angeordnet ist.

9. Folienaufbau nach einem der Ansprüche 1 bis 8,
wobei die Materialmischung aus Silber und Carbon einen Silberanteil von größer als 40% und einen Carbonanteil von kleiner als 60% aufweist.

10. Verfahren zum Herstellen eines Folienaufbaus mit elektrischer Funktionalität und externer Kontaktierung, umfassend:
- Bereitstellen des Folienaufbaus (1) mit einer Trägerfolie (200), wobei der Folienaufbau (1) einen Bereich (10) mit einer elektrischen Übertragungsstrecke (30) und einen Kontaktierungsbereich (20) zur externen Kontaktierung der elektrischen Übertragungsstrecke (30) aufweist,
- Herstellen einer Materialmischung aus Silber und Carbon,
- Drucken der Materialmischung als eine elektrisch leitfähige Schicht (100) in dem Kontaktierungsbereich (20) des Folienaufbaus oberhalb der Trägerfolie (200).

11. Verfahren nach Anspruch 10,
wobei die Materialmischung aus Silber und Carbon in dem Bereich (10) des Folienaufbaus mit der elektrischen Übertragungsstrecke (30) und in dem Kontaktierungsbereich (20) des Folienaufbaus auf die Trägerfolie (200) aufgedruckt wird, wobei die elektrisch leitfähige Schicht (100) die elektrische Übertragungsstrecke (30) bildet.

12. Verfahren nach Anspruch 11,
wobei eine Isolationsschicht (300) in dem Bereich (10) des Folienaufbaus mit der elektrischen Übertragungsstrecke (30) auf die elektrisch leitfähige Schicht (100) aufgebracht wird und die elektrisch leitfähige Schicht (100) in dem Kontaktierungsbereich (20) des Folienaufbaus freiliegend angeordnet ist.

13. Verfahren nach Anspruch 10,
- wobei auf der Trägerfolie (200) eine Leiterbahn (400) aufgebracht wird, und die Leiterbahn (400) einen ersten Abschnitt (410), der in dem Kontaktierungsbereich (20), und einen zweiten Abschnitt (420), der in dem Bereich (10) mit der elektrischen Übertragungsstrecke (30), angeordnet ist, aufweist und der zweite Abschnitt (420) der Leiterbahn (400) die elektrische Übertragungsstrecke (30) bildet,
- wobei die Materialmischung aus Silber und Carbon in dem Kontaktierungsbereich (20) des Folienaufbaus auf die Leiterbahn (400) aufgedruckt wird.

14. Verfahren nach Anspruch 13,
wobei eine Isolationsschicht (300) in dem Bereich (10) des Folienaufbaus mit der elektrischen Übertragungsstrecke (30) auf die Leiterbahn (400) aufgebracht wird und die elektrisch leitfähige Schicht (100) in dem Kontaktierungsbereich (20) des Folienaufbaus freiliegend angeordnet ist.

15. Verfahren nach einem der Ansprüche 10 bis 14,
wobei die Materialmischung aus Silber und Carbon vor dem Aufdrucken mit einem Silberanteil von größer als 40% und einem Carbonanteil von kleiner als 60% gemischt wird.
